# EUROPEAN PATENT SPECIFICATION

(11) **EP 3 642 579 B1**
(45) Date of publication and mention of the grant of the patent: **10.03.2021**
(21) Application number: 18729958.1
(22) Date of filing: 07.06.2018
(51) Int. Cl.: H04N 5/369, G01J 1/02, G01J 1/44, G01J 5/02, G01J 5/10, G01J 5/00, G01J 1/42, G01J 3/28, G01J 3/36

(54) **A DEVICE HAVING A CMOS VL AND IR IMAGING SYSTEM**
VORRICHTUNG MIT CMOS-VL UND IR-BILDGEBUNGSSYSTEM
DISPOSITIF POSSÉDANT UN SYSTÈME D'IMAGERIE CMOS VL ET IR

(30) Priority: 22.06.2017 US 201715630271
(43) Date of publication of application: 29.04.2020
(73) Proprietor: Robert Bosch GmbH, 70442 Stuttgart (DE)
(72) Inventor: LAJEVARDI, Pedram, Menlo Park, California 94025 (US); BLECHSCHMIDT, Rainer, Mountain View, California 94041 (US)
(86) International application number: PCT/EP2018/065073
(87) International publication number: WO 2018/234060

(56) References cited:
- WO-A1-2014/063117
- US-A- 6 107 618
- US-A1- 2006 055 800
- US-A1- 2012 126 121
- US-A1- 2015 115 134
- US-A1- 2016 240 579

## Description

### FIELD

This disclosure relates generally to electronic devices and, more particularly, to a device having a complementary metal oxide (CMOS) visual light (VL) and infrared (IR) imaging systems and methods thereof.

### BACKGROUND

Dual imaging sensors are known from US2016/240579, US2006/055800, WO2014/063117 and US6107618.

### SUMMARY

A summary of certain embodiments disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects that may not be set forth below.

Embodiments of the disclosure related to a device having a complementary metal oxide (CMOS) visual light (VL) and infrared (IR) imaging systems and methods thereof. The device may be a security device, a surveillance device, a consumer digital device, an electronic device, a thin client, a thick client, an automotive device, an object detector, as well as any suitable devices.

In one aspect of the disclosure, the device comprises a camera having a dual VL and IR imaging sensors, a readout assembly communicatively coupled to the dual VL and IR imaging sensors, an user interface for displaying an image captured by the camera, a processor for processing the captured image, and a memory for storing the processed image is located remotely from the device, the memory in communication with at least one of the user interface or the processor. The readout assembly comprises a readout circuit vertically stacked on the dual VL and IR imaging sensors. The dual VL and IR imaging sensors comprises a plurality of visual light (VL) imaging pixels for capturing first image data in response to the visual light (VL) and an infrared (IR) imaging pixels for capturing second image data in response to IR wavelength ranges between 850 nm and 14000000 nm, wherein the IR imaging pixels are read out by the vertically stacked readout circuit. The device further comprises a column readout assembly as specified in claim 1. The device further comprises a controller configured to operate at least one of the VL imaging pixels and the IR imaging pixels and switching elements connected to the controller to switch the camera between an IR imaging mode and a VL imaging mode. When the camera in the IR imaging mode, the VL imaging pixels are deactivated. When the camera in the IR imaging mode, the IR imaging pixels are deactivated.

In another aspect of the disclosure, a device comprises a camera having a dual VL and IR imaging sensors and a readout assembly communicatively coupled to the dual VL and IR imaging sensors, the readout assembly comprising a first readout circuit and a second readout circuit, an user interface for displaying an image captured by the camera, a processor for processing the captured image, and a memory for storing the processed image. The dual VL and IR imaging sensors comprises a plurality of visual light (VL) imaging pixels for capturing first image data in response to the visual light (VL) and an infrared (IR) imaging pixels for capturing second image data in response to IR wavelength ranges between 850 nm and 14000000 nm. The first readout circuit is vertically stacked on the dual VL and IR imaging sensors, wherein the IR imaging pixels are read out by the first readout circuit. The second readout circuit is a column readout circuit and the VL imaging pixels are read out by the second readout circuit. The device further comprises a controller configured to operate at least one of the VL imaging pixels and the IR imaging pixels and switching elements connected to the controller to switch the camera between an IR imaging mode or a VL imaging mode. When the camera in the IR imaging mode, the VL imaging pixels are deactivated. When the camera in the IR imaging mode, the IR imaging pixels are deactivated. The camera further comprises a housing and a carrier mechanically coupled to the housing for encapsulating the camera, defining a camera package.

### BRIEF DESCRIPTION OF THE DRAWINGS

These and other features, aspects, and advantages of this disclosure will become better understood when the following detailed description of certain exemplary embodiments is read with reference to the accompanying drawings in which like characters represent like arts throughout the drawings, wherein:
FIG. 1 is a diagram depicting an embodiment of a multi-spectral visual light (VL) and infrared (IR) imaging system.
FIG. 2 is a functional block diagram depicting an embodiment of a super pixels imaging system.
FIG. 3 is a cross-sectional view depicting another embodiment of a super pixels imaging system.
FIG. 4 is a function block diagram depicting an embodiment of a device incorporating a visual light (VL) and infrared (IR) imaging system.

### DETAILED DESCRIPTION

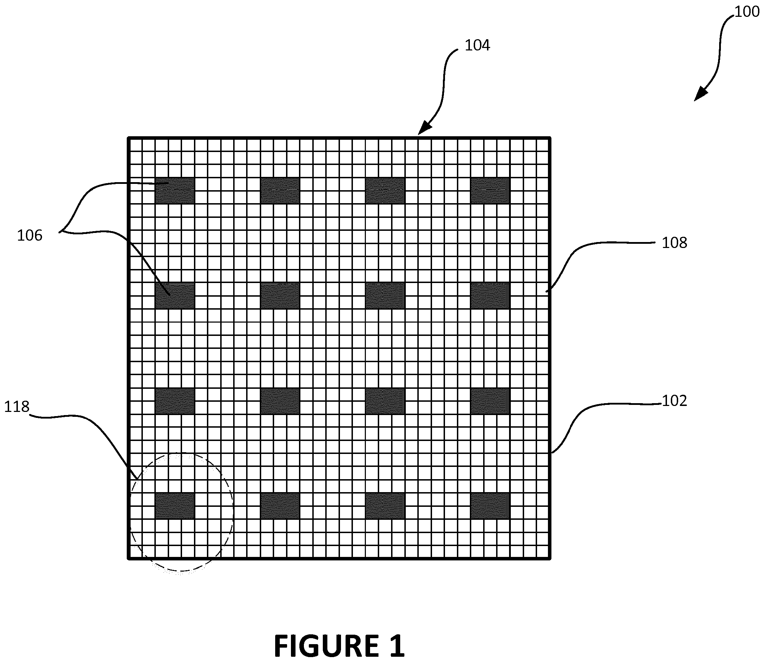

FIG. 1 is a complementary metal oxide semiconductor (CMOS) multi-spectral visual light (VL) and infrared (IR) imaging system 100. The system 100 comprises a plurality of super pixel groups 118 arranged in a two-dimensional array. Each super pixel group 118 in the plurality of super pixel groups comprises a first plurality of individual imaging sensors or pixels 108 that are sensitive to visible light (VL) and a second plurality of individual IR imaging sensors or pixels 106 that are sensitive to heat, IR, and/or near IR (NIR) in the range between 850 nm - 14000000 nm. Different information is carried at different wavelengths by the VL imaging sensors 108 and the IR imaging sensors 106. A carrier or a substrate 102 is provided for supporting the VL imaging sensors 108 and the IR imaging sensors 106. In one embodiment, the plurality of VL imaging sensors capture first image data in response to the visual light (VL) and the infrared (IR) imaging sensors capture second image data in response to heat, IR, and/or near IR (NIR). The IR imaging sensors configured to generate thermal signals after a presence of a target is detected and operate the CMOS imaging sensors. The target may be a person, an animal, or any suitable objects that radiate heat, IR, and/or near IR (NIR).

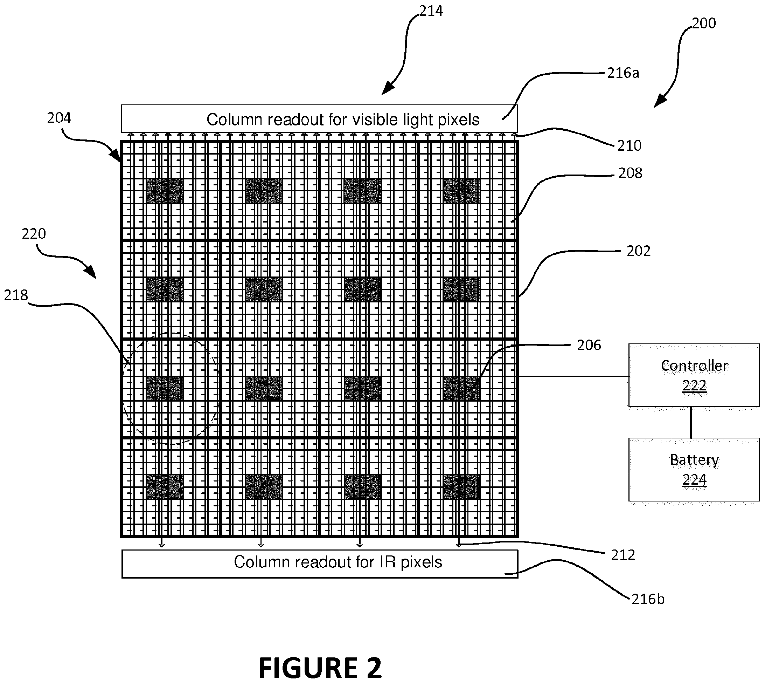

FIG. 2 is a functional block diagram depicting an embodiment of a super pixels imaging system 200 that is configured for simultaneous operation as a VL imaging device and as an IR imaging device. The super pixel imaging system 200 is one example implementation of a multi-spectral VL and infrared IR imaging system 100 depicted in FIG. 1. The illustrated embodiment of the super pixels imaging system 200 comprises a plurality of pixel elements 220 grouped together into 8x8 arrangements of super pixels 218. As used herein, the term "super pixel" refers to a group of individual pixels in the super pixels 220 where some pixels, such as pixels 206, operate as IR imaging sensors while the remaining pixels, such as pixels 208, operate as VL imaging sensors. Of course, the configuration of pixels depicted in FIG. 2 is merely illustrative of one example of pixel configurations. Alternative embodiments can use different arrangements of IR imaging sensor and VL imaging sensors other than the one example depicted in FIG. 2 without departing from the scope of the disclosure. The super pixel imaging system 200 further comprises a readout assembly 214 having a first column readout circuity 216a and a second column readout circuitry 216b. According to an example not falling under the scope of the invention VL image data is readout by the first column readout circuity 216a and the IR image data is readout by the second column readout circuitry 216b. As illustrated, the first column readout circuity 216a coupled to the super pixels 220 readout a row of VL image data along readout column lines 210. The second column readout circuity 216b, located opposite from the first column readout circuitry 216a and is coupled to the super pixels 220 readout a row of IR image data along readout column lines 212.

The super pixels imaging system 200 further comprises a controller 222 configured to operate the super pixels 220. The controller 222 is a control device that incorporates at least one of analog and digital control circuity to operate the super pixels imaging system 200. In some embodiments, the controller 222 is implemented using CMOS digital logic circuits that are physically integrated with the super pixels imaging system 200. In another embodiment, the controller 222 is a discrete control device that is operatively connected to the super pixels imaging system 200 either on a 3D stacked configuration system, mounted back-to-back configuration system, positioned side-by-side configuration system, or other suitable connection. During operation, the controller 222 is configured to operate the VL imaging sensor 208, the IR imaging sensor 206, or both the VL and IR imaging sensors. In one embodiment, the controller 222 operates switching elements in the pixels or super pixels within the imaging system to either switch the pixels or the system between an IR imaging mode and a VR imaging mode. In another embodiment, the controller 222 is connected to switching circuits for each pixel to control the operating mode of each pixel element. In yet another embodiment, the controller 222 is connected to switching circuits for each super pixel group to either activate or deactivate the VL imaging sensor and vice versa. In further yet another embodiment, based on the heat information detected by the IR imaging sensor, the controller 222 is connected to switching circuits for each super pixel group to either activate the VL imaging sensor when an object is presence and deactivate the VL imaging sensor when the object is not presence.

The super pixels imaging system 200 further comprises a processor for processing and evaluating sensor signals generated by the VL imaging sensor 208 and/or the IR imaging sensor 206 and an energy storage device 224 for providing energy power to operate the controller 222, the super pixels 220, and other components in the super pixels imaging system 200 when needed. The energy storage device 224 may be a battery, a super capacitor, or other suitable energy storage device. The super pixels imaging system 200 may be incorporate into security cameras, security devices, surveillance cameras, surveillance devices, consumer digital cameras, consumer digital devices, thin clients, thick clients, industrial machine vision systems, automotive cameras, home furnishing cameras, residential cameras, commercial cameras, object detectors, and so forth.

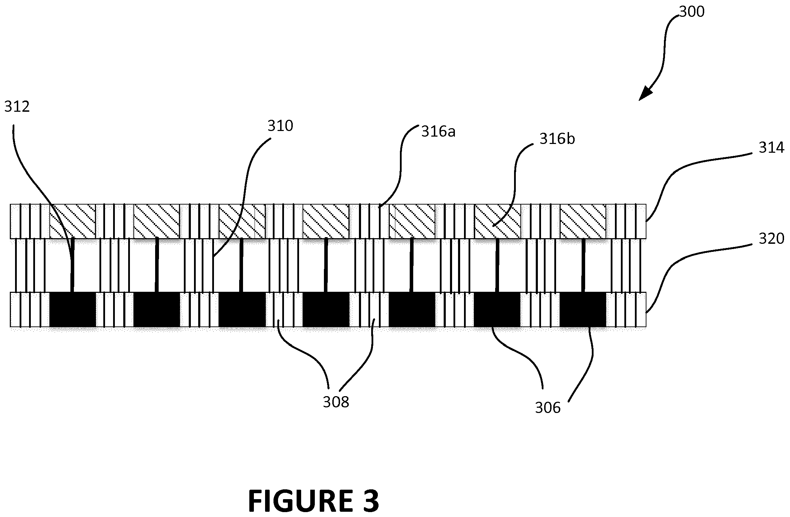

FIG. 3 is a cross-sectional view depicting another example of a super pixels imaging system 300 that is configured for simultaneous operation as a VL imaging device and as an IR imaging device. Unlike from the super pixel imaging system 200, the super pixel imaging 300 comprises a readout assembly 314 either vertically mounted to or vertically stacked on a plurality of pixel elements grouped together into super pixels 320. In one example, individual pixel 306, 308 can be read out by the readout assembly 314. In another example, a plurality of the same pixel 306 or 308 as a group can be read out by the readout assembly 314. In yet another example, a combination of pixels 306, 308 can be read out by the readout assembly 314. Further yet another example, the pixels 306, 308 can be read out by more than one readout circuit of the readout assembly 314. As illustrated, the readout assembly 314 comprises a first readout circuit 316a and a second readout circuit 316b. A plurality of IR pixels 306 share the same readout circuit 316b are vertically read out by the second readout circuit 316b whereas a plurality VL pixels 308 spared the same readout circuit 316a are vertically read out by the first readout circuit 316a. According to the invention, a combination of a column readout circuit and a vertical readout circuit, defined as a readout assembly, is connected to a plurality of the super pixels 320. According to an example not part of the invention, the IR pixels 306 can be read out by the column readout circuit 216b illustrated in FIG. 2 whereas the VL pixels 308 can be read out by the vertical readout circuit 314. Vice versa, according to the invention, the IR pixels 306 can be read out by the vertical readout circuit 314 whereas the VL pixels 308 can be read out by the column readout circuit 216a illustrated FIG. 2.

Now back to FIG. 3, VL readout lines 310 coupled the readout assembly 314 to the super pixels 320 where image data are transmitted along the readout lines 310 are readout by the readout assembly 314. IR readout lines 312 coupled the readout assembly 314 to the super pixels 320 where image data are transmitted along the readout lines 312 are readout by the readout assembly 314.

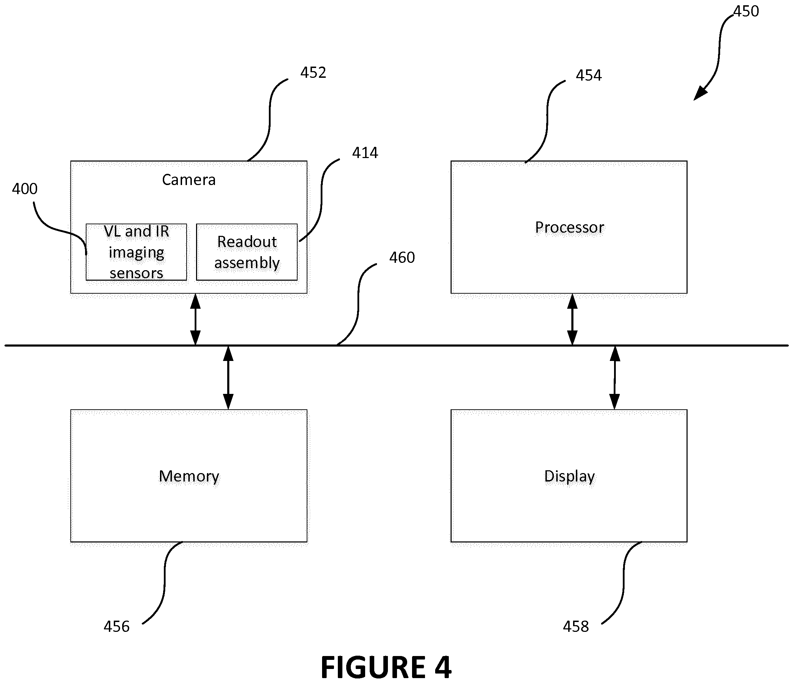

FIG. 4 is a functional block diagram depicting a device 450 having a camera 452 that is configured for simultaneous operation as a VL and IR imaging system. The camera 452 comprises a dual VL and imaging sensors 400, similar to those previously described sensors depicted in FIGs. 1-3 and a readout assembly 414. In addition, the device 450 comprises a processor 454, a non-transitory computer-readable storage media or a memory 456, and a display 458 communicatively coupled to the rest of the modules 452, 454, 456 via a bus 460. Any other suitable computer modules such as an input/output (I/O), communication interface, and so forth may be communicatively coupled via the bus 460. Once an image is captured by the camera 452, the captured image is transmitted to the processor 454 for processing. The processor 454 may be a general or special purpose microprocessor operating under control of computer executable instructions, such as program modules, being executed by a client machine. Program modules generally include routines, programs, objects, components, data structure and the like that perform particular tasks or implement particular abstract types. In one embodiment, some or all of the sub-processors may be implemented as computer software tangibly stored in a memory to perform their respective functions when executed. In alternate embodiment, some or all of the sub-processors may be implemented in an ASIC. In some embodiments, the captured image may be transfer to an external electronic device, either wirelessly or wired for processing.

The processed image or the captured image can be either locally stored on the memory 456, remotely stored on a cloud, or both, temporary or permanently. The captured image or processed image may then be transmitted to the display 458 for display.

Embodiments within the scope of the disclosure may also include non-transitory computer-readable storage media or machine-readable medium for carrying or having computer-executable instructions or data structures stored thereon. Such non-transitory computer-readable storage media or machine-readable medium may be any available media that can be accessed by a general purpose or special purpose computer. By way of example, and not limitation, such non-transitory computer-readable storage media or machine-readable medium can comprise RAM, ROM, EEPROM, CD-ROM or other optical disk storage, magnetic disk storage, a cloud memory or other magnetic storage devices, or any other medium which can be used to carry or store desired program code means in the form of computer-executable instructions or data structures. Combinations of the above should also be included within the scope of the non-transitory computer-readable storage media or machine-readable medium.

Embodiments may also be practiced in distributed computing environments where tasks are performed by local and remote processing devices that are linked (either by hardwired links, wireless links, or by a combination thereof) through a communications network.

Computer-executable instructions include, for example, instructions and data which cause a general purpose computer, special purpose computer, or special purpose processing device to perform a certain function or group of functions. Computer-executable instructions also include program modules that are executed by computers in stand-alone or network environments. Generally, program modules include routines, programs, objects, components, and data structures, etc. that perform particular tasks or implement particular abstract data types. Computer-executable instructions, associated data structures, and program modules represent examples of the program code means for executing steps of the methods disclosed herein. The particular sequence of such executable instructions or associated data structures represents examples of corresponding acts for implementing the functions described in such steps.

While the patent has been described with reference to various embodiments, it will be understood that these embodiments are illustrative and that the scope of the disclosure is not limited to them. Many variations, modifications, additions, and improvements are possible. More generally, embodiments in accordance with the patent have been described in the context or particular embodiments. Functionality may be separated or combined in blocks differently in various embodiments of the disclosure or described with different terminology. These and other variations, modifications, additions, and improvements may fall within the scope of the disclosure as defined in the claims that follow.

## Claims

1. A device (100; 300) comprising:
a camera (452), the camera (452) comprising:
a dual visual light, VL, and infrared, IR, imaging sensor (106, 108; 306, 308; 400), comprising:
a plurality of VL imaging pixels (108; 308) for capturing first image data in response to the visual light, and
IR imaging pixels (106; 306) for capturing second image data in response to IR wavelength ranges between 850 nm and 14000000 nm; and
a readout assembly (314; 414) communicatively coupled to the dual VL and IR imaging sensor (106, 108, 208; 400), the readout assembly (314; 414) comprising a readout circuit (314) vertically stacked on the dual VL and
IR imaging sensor (106, 108; 306, 308; 400) a column readout assembly (214) comprising a column readout circuit (216a);
a user interface (458) for displaying an image captured by the camera (452);
a processor (454) for processing the captured image; and
a memory (456) for storing the processed image being located remotely from the device (100; 300), wherein the memory (456) is in communication with at least one of the user interface (458) or the processor (454),
**characterized in that**:
the IR imaging pixels (106; 306) are read out by the vertically stacked readout circuit (314) ; and
the VL imaging pixels (108; 308) are read out by the column readout circuit (216a).

2. The device (100; 300) of claim 1 further comprising a controller, the controller being configured to operate at least one of the VL imaging pixels (108; 308) and the IR imaging pixels (106; 306).

3. The device (100; 300) of claim 2 further comprising switching elements connected to the controller to switch the camera (452) between an IR imaging mode or a VL imaging mode.

4. The device (100; 300) of claim 3 wherein the camera (452) in the IR imaging mode, the VL imaging pixels are deactivated.

5. The device (100; 300) of claim 3 wherein the camera (452) in the IR imaging mode, the IR imaging pixels are deactivated.

6. The device (100; 300) of claim 1 wherein the device (100; 300) is a mobile electronic device, a portable device, a wearable device, an automotive device.

## Patentansprüche

1. Einrichtung (100; 300), umfassend:
eine Kamera (452), wobei die Kamera (452) umfasst:
einen Doppel-Sichtbares-Licht-, VL-, und Infrarot-, IR-, Bildgebungssensor (106, 108; 306, 308; 400), umfassend:
mehrere VL-Bildgebungspixel (108; 308) zum Erfassen erster Bilddaten als Reaktion auf das sichtbare Licht, und
IR-Bildgebungspixel (106; 306) zum Erfassen zweiter Bilddaten als Reaktion auf IR-Wellenlängenbereiche zwischen 850 nm und 14 000 000 nm; und
eine Auslesebaugruppe (314; 414) kommunikativ an den Doppel-VL- und IR-Bildgebungssensor (106, 108, 208; 400) gekoppelt, wobei die Auslesebaugruppe (314; 414) eine vertikal auf dem Doppel-VL- und IR-Bildgebungssensor (106, 108; 306, 308; 400) gestapelte Ausleseschaltung (314) umfasst,
wobei eine Spaltenauslesebaugruppe (214) eine Spaltenausleseschaltung (216a) umfasst;
eine Benutzerschnittstelle (458) zum Anzeigen eines durch die Kamera (452) erfassten Bilds;
einen Prozessor (454) zum Verarbeiten des erfassten Bilds; und
einen Speicher (456) zum Speichern des verarbeiteten Bilds, entfernt angeordnet von der Einrichtung (100; 300), wobei der Speicher (456) mit mindestens einer der Benutzerschnittstelle (458) oder dem Prozessor (454) in Kommunikation steht,
**dadurch gekennzeichnet, dass**:
die IR-Bildgebungspixel (106; 306) durch die vertikal gestapelte Ausleseschaltung (314) ausgelesen werden; und
die VL-Bildgebungspixel (108; 308) durch die Säulenausleseschaltung (216a) ausgelesen werden.

2. Einrichtung (100; 300) nach Anspruch 1, weiter umfassend einen Controller, wobei der Controller konfiguriert ist zum Betreiben mindestens eines der VL-Bildgebungspixel (108; 308) und der IR-Bildgebungspixel (106; 306).

3. Einrichtung (100; 300) nach Anspruch 2, weiter umfassend mit dem Controller verbundene Schaltelemente zum Schalten der Kamera (452) zwischen einem IR-Bildgebungsmodus oder einem VL-Bildgebungsmodus.

4. Einrichtung (100; 300) nach Anspruch 3, wobei die Kamera (452) im IR-Bildgebungsmodus, die VL-Bildgebungspixel deaktiviert sind.

5. Einrichtung (100; 300) nach Anspruch 3, wobei die Kamera (452) im IR-Bildgebungsmodus, die IR-Bildgebungspixel deaktiviert sind.

6. Einrichtung (100; 300) nach Anspruch 1, wobei die Einrichtung (100; 300) eine mobile elektronische Einrichtung, eine tragbare Einrichtung, eine Wearable-Einrichtung, eine automotive Einrichtung ist.

## Revendications

1. Dispositif (100; 300) comprenant :
une caméra (452), la caméra (452) comprenant :
un double capteur d'imagerie à lumière visible, VL, et infrarouge, IR (106, 108; 306, 308 ; 400), comprenant :
une pluralité de pixels d'imagerie VL (108; 308) pour capturer les premières données d'image en réponse à la lumière visible, et
des pixels d'imagerie IR (106; 306) pour la capture de secondes données d'image en réponse à des plages de longueur d'onde IR comprises entre 850 nm et 14000000 nm ; et
un ensemble de lecture (314; 414) couplé de manière communicative au double capteur d'imagerie VL et IR (106, 108, 208 ; 400), l'ensemble de lecture (314; 414) comprenant un circuit de lecture (314) empilé verticalement sur le double capteur d'imagerie VL et IR (106, 108; 306, 308 ; 400) un ensemble de lecture de colonne (214) comprenant un circuit de lecture de colonne (216a) ;
une interface utilisateur (458) pour l'affichage d'une image capturée par la caméra (452) ;
un processeur (454) pour traiter l'image capturée ; et
une mémoire (456) pour le stockage de l'image traitée étant située à distance de l'appareil (100, 300), la mémoire (456) étant en communication avec au moins l'un de l'interface utilisateur (458) ou du processeur (454),
**caractérisé en ce que** :
les pixels d'imagerie IR (106; 306) sont lus par le circuit de lecture empilé verticalement (314)
les pixels d'imagerie VL (108; 308) sont lus par le circuit de lecture de colonne (216a).

2. Dispositif (100; 300) selon la revendication 1, comprenant en outre un dispositif de commande, le dispositif de commande étant configuré pour faire fonctionner au moins un des pixels d'imagerie VL (108; 308) et des pixels d'imagerie IR (106; 306).

3. Dispositif (100; 300) selon la revendication 2, comprenant en outre des éléments de commutation connectés au dispositif de commande pour commuter la caméra (452) entre un mode d'imagerie IR ou un mode d'imagerie VL.

4. Dispositif (100; 300) selon la revendication 3, la caméra (452) en mode d'imagerie IR, les pixels d'imagerie VL étant désactivés.

5. Dispositif (100; 300) selon la revendication 3, la caméra (452) en mode d'imagerie IR, les pixels d'imagerie IR étant désactivés.

6. Dispositif (100; 300) selon la revendication 1, le dispositif (100; 300) étant un dispositif électronique mobile, un dispositif portatif, un dispositif portable, un dispositif automobile.
